# EUROPEAN PATENT APPLICATION

(11) **EP 4 219 167 A1**
(43) Date of publication of application: **02.08.2023**
(21) Application number: 23154408.1
(22) Date of filing: 01.02.2023
(51) Int. Cl.: B41F 23/04, B05D 3/06, B41J 11/00, F21V 29/51, F21V 29/74, F21V 29/77

(54) **COOLING SYSTEM FOR LED CURING APPARATUS**

(30) Priority: 01.02.2022 GB 202201294; 01.02.2022 GB 202201298; 20.10.2022 GB 202215540
(71) Applicant: GEW (EC) Limited, Crawley, West Sussex RH10 9QR (GB)
(72) Inventor: RAE, Malcolm, RH10 9QR Crawley (GB); HICKS, James, RH10 9QR Crawley (GB); RAE, Robert, RH10 9QR Crawley (GB)
(74) Representative: Windsor, Louise

(57) **Abstract**

An LED curing apparatus cooling system (1) comprising at least one LED mount (3) for mounting a plurality of LEDs (5); at least one bore (11) in the LED mount (3); at least one thermal transfer member (9) comprising an evaporator section and a condenser section, wherein the or each thermal transfer member (9) is removably connected to a bore (11); and wherein each thermal transfer member (9) comprises a collar (7) having an outer surface to mate with an inner surface of a bore (11).

## Description

The present invention relates to an improved cooling system for an LED print curing apparatus.

The use of LED (light-emitting diode) arrays for print curing is becoming increasingly popular as an alternative to traditional mercury arc lamps. Due to the high temperatures generated by the use of large LED arrays, cooling systems must be provided to prevent the LEDs overheating.

In some examples, the LEDs are provided on a base having a heat sink and heat pipes are used to draw heat away from the LEDs to a cooling module positioned away from the LEDs. The cooling module may be air-cooled or water-cooled. The heat pipes have an evaporator section near to the LEDs and a condenser section at or near to the cooling module. An example of such a system is known from the applicant's earlier patent publication, EP3406446.

In order to provide sufficient thermal efficiency, the copper heat pipes are soldered to the base and provided as a pre-built unit. Whilst such a known system provides efficient cooling of the LEDs, because the heat pipes are soldered to the base and provided as a pre-built unit, attachment of the delicate LEDs to the base is difficult. Existing system are constrained by soldering requirements, which require the thermal transfer members, such as heat pipes, to be soldered for attachment before the delicate LED modules are attached later. Once the delicate LEDs are secured and thermally coupled to the heat sink on which they are mounted it is not possible to solder the thermal transfer members, such as heat pipes or metal rods, to secure them to the heat sink because of the likelihood of damaging the LEDs. Furthermore, the use of existing joining techniques, such as soldering, is problematic if two different metals are used for the base and the heat pipes. For example, if a copper rod or heat pipe is used with a dissimilar metal base, this would require an additional coating to allow the components to be soldered together. Copper is an expensive material, which is heavy and difficult to machine. Thus, there exists a need to improve the connection between heat pipes and LED heat sinks in LED print curing apparatus.

The present invention sets out to provide an improved LED support for use in an LED print curing apparatus, which alleviates the problems described above.

In one aspect, the invention provides an LED curing apparatus cooling system comprising at least one LED mount for mounting a plurality of LEDs;
at least one bore in the LED mount;
at least one thermal transfer member removably connected to a bore;
wherein each thermal transfer member comprises a collar having an outer surface to mate with an inner surface of a bore.

Preferably, the at least one thermal transfer member is a metal rod.

Preferably, the collar is attached to a first end of the metal rod.

Preferably, the collar and the metal rod are formed as a single piece.

Preferably, the outer surface of the or each collar is shaped to mate with a shaped inner surface of a respective bore.

Optionally, the or each thermal transfer member comprises a heat pipe comprising an evaporator section and a condenser section, wherein the or each heat pipe is removably connected to a bore; and
wherein each heat pipe comprises a collar having an outer surface to mate with an inner surface of a bore.

The present invention offers a significant improvement to the mechanical coupling of the thermal transfer members, such as a metal rod/s or heat pipe/s, to the LED mount because it does not require requiring soldering of the thermal transfer member (heat pipe or metal rod) to the LED mount. This allows for ease of installation and in-field repair - i.e., if a metal rod or heat pipe requires replacement. The improved configuration allows for coupling of the LED mount to the heat pipe after the delicate LEDs are mounted. The mechanical coupling improves the installation process whilst also ensuring that the required thermal coupling is achieved to allow efficient and uniform cooling of the LED curing apparatus along the full length of the apparatus.

Preferably, the collar is attached to a first end of the thermal transfer member.

Preferably, the collar is attached to the evaporator section of the heat pipe.

Preferably, the outer surface of the or each collar is shaped to mate with a shaped inner surface of a respective bore.

Preferably, the outer surface of the or each collar comprises a threaded portion to mate with a threaded inner surface of a respective bore.

Preferably, the threaded portion is a substantial part of the or each collar.

A threaded mating engagement between the collar and the inner surface of the bore into which it is received is a significant improvement offered by the present invention. The threaded collar can be tightened to a precise torque, which provides a user with a guide to correct installation - i.e., to ensure that the threaded engagement is as required. Slight over tightening of the threaded engagement distorts the pitch and forces more of the threaded section of the collar into contact with the corresponding threaded section of the respective bore in the body of the cooling system. The present invention provides the optimum heat transfer from the LED mount to the thermal transfer member/s, such as a metal rod/s or heat pipe/s.

Preferably, the or each collar is a connecting band; more preferably, an annular band.

Optionally, the or each collar is cylindrical having a base at a first end and an opening at an opposing second end.

Preferably, the or each thermal transfer member is soldered to the collar.

Preferably, the or each metal rod is soldered to the collar.

Preferably, the or each heat pipe is soldered to a collar.

Preferably, the LED mount comprises a thermal transfer material between the or each thermal transfer member and the bore.

Preferably, the LED mount comprises a thermal transfer material between the or each metal rod and the bore.

Preferably, the LED mount comprises a thermal transfer material between the or each heat pipe and the bore.

Preferably, the thermal transfer material is a high performance thermal interface material. More preferably, the thermal transfer material has a thermal conductivity greater than about 5W/mK.

Preferably, the thermal transfer material is a ceramic paste.

Preferably, the thermal transfer material is provided between the collar and the bore to which the collar is removably connected.

The use of a thermal transfer material, in particular a paste, minimises the risk of voids forming between the base of the threaded collar in the region where the collar meets the LED mount. This means that there are no barriers to heat transfer so that optimum thermal transfer is achieved. Thermal transfer paste used between the collar and the heat sink can be very well controlled and only a thin layer is required to achieve a minimum thermal resistance.

By soldering the thermal transfer member, such as a metal rod or heat pipe, and a collar together, a solid junction is permanently provided between the two surfaces. The dimensions of the collar of the present invention can be well-controlled, which allows for soldering to a respective thermal transfer member (metal rod or heat pipe) and for any variation in the shape of the thermal transfer member (metal rod or heat pipe). The configuration of the collar allows for subsequent fitting into the LED mount that minimises thermal resistance.

The present invention optimises heat transfer away from the cooling system and so from LEDs mounted thereon. The use of efficient thermal transfer members, for example metal rods or using heat pipe technology, allows for an optimal print curing effect to be achieved, whilst the LEDs can be operated at full power. By ensuring that the risk of overheating is minimised, if not eliminated, the LEDs last longer before it is necessary to replace them; whilst maintenance requirements are reduced. The thermal transfer members/metal rods/heat pipes and collars of the present invention could also be re-used if the LED module fails, which reduces waste and so the impact of the system on the environment. Thus, the present invention offers significant cost and environmental benefits.

The present invention offers a significant improvement to the method of assembling an LED curing system in allowing the thermal transfer members/metal rods/heat pipes to be mounted adjacent to the LED mount *after* the LEDs have been mounted on the LED mount. The arrangement of the present invention also allows for a modular system that is configured for ease of installation and reduces the risk of damage to the LEDs.

Preferably, the cooling system comprises one or more LEDs mounted on the LED mount.

Preferably, the or each thermal transfer member is positioned adjacent to the LEDs.

Preferably, the or each metal rod is positioned adjacent to the LEDs.

Preferably, the or each heat pipe is positioned adjacent to the LEDs.

Preferably, the LED mount comprises aluminium.

Preferably, the LED mount comprises an aluminium block.

The aluminium block of the present invention is configured according to the lamphead with which the cooling system is to be used. Thus, the cooling system of the present invention can be retro-fitted to existing lampheads. The dimensions of the block can be accurately machined from aluminium for ease of installation and maintenance. Furthermore, the cooling system is compatible with the small volume available in a print curing apparatus and does not interfere with the mounting/substrate-facing surface of the lamphead.

Preferably, the or each collar comprises copper.

Preferably, the or each collar comprises a threaded portion and a non-threaded portion. Preferably, the or each collar comprises a threaded portion and a smooth portion.

The present invention allows for any variation in the size and shape of each metal transfer member; for example, a heat pipe at the evaporator section that is received in the LED mount. Using thermal transfer paste alone is problematic because the thickness of the paste between a series of heat pipes and the LED mount into which they are received would vary. Any such variation would lead to a variation in the thermal resistance along and across a curing apparatus. The arrangement of the present invention, wherein each collar is accurately machined to tightly fit into the bore into which it is received, improves the heat transfer and also the uniformity of heat transfer along and across the curing apparatus.

Preferably, the or each bore is substantially cylindrical.

In a further aspect, the present invention provides a cooling module comprising the cooling system for an LED print curing apparatus as previously described, wherein the or each thermal transfer member is also connected to at least one air-cooled heat sink.

Preferably, the thermal transfer member is a metal rod or a heat pipe.

Preferably, the cooling module comprises at least one finned heat sink.

According to another aspect of the present invention, there is provided a print curing apparatus comprising a cooling system as described herein.

Preferably, the print curing apparatus is a UV curing apparatus.

In a further aspect, the invention provides a cooling module, which is securable to one or more thermal transfer members for an LED curing apparatus, wherein the cooling module comprises:
a first finned heat sink and a second finned heat sink;
wherein the first finned heat sink is removably securable to the second finned heat sink to provide at least one aperture therebetween and,
wherein each of a plurality of fins protrude from the first finned heat sink and from the second finned heat sink and each fin is substantially perpendicular to the length of the or each aperture.

It is understood that "length" refers to the longest dimension of the aperture.

Preferably, the or each thermal transfer member is a heat pipe.

Optionally, the or each thermal transfer member is a metal rod or a metal pipe. Further optionally, the or each thermal transfer member is a copper rod or a copper pipe.

Preferably, the first finned heat sink and the second heat sink are extruded.

Optionally, the first finned heat sink and the second heat sink comprise a plurality of blades. Further optionally, the first finned heat sink and the second heat sink comprise a plurality of skived fins or blades.

Preferably, the at least one aperture is substantially cylindrical.

Preferably, the cooling module comprises a row of apertures. More preferably, a row of substantially cylindrical apertures.

Preferably, the cooling module comprises a row of apertures along its midline, wherein an inner surface of the first finned heat sink is proximal to an inner surface of the second finned heat sink substantially along the midline of the cooling module.

It is understood that in the context of this invention "proximal to" means that the first finned heat sink is close to the second finned heat sink.

It is understood that in the context of this invention the "midline" of the cooling module is the line or plane of the body of the cooling module equidistant from the outer finned surfaces of the first and second finned heat sinks. The outer surfaces are furthest from the length of the thermal transfer member (such as metal rods or heat pipes) in use.

Preferably, the cooling modules comprises one or more metal rods; more preferably, the or each metal rod is cylindrical.

Preferably, the cooling module comprises one or more heat pipes; more preferably, the or each heat pipe is substantially cylindrical.

Preferably, the or each metal rod is substantially in contact with the wall of the aperture into which it is received.

Preferably, the or each heat pipe is substantially in contact with the wall of the aperture into which it is received.

Preferably, the first finned heat sink and the second finned heat sink are secured to the or each thermal transfer member.

Preferably, the first finned heat sink and the second finned heat sink are secured to the or each metal rod.

Preferably, the first finned heat sink and the second finned heat sink are secured to the or each heat pipe.

Preferably, the first finned heat sink is spaced apart from the second finned heat sink by the or each thermal transfer member.

Preferably, the first finned heat sink is spaced apart from the second finned heat sink by the or each metal rod.

Preferably, the first finned heat sink is spaced apart from the second finned heat sink by the or each heat pipe.

Preferably, the first finned heat sink is spaced apart from the second finned heat sink by the or each thermal transfer member along the mid-line of the cooling module; preferably, wherein the or each thermal transfer member is a metal rod or a heat pipe.

Preferably, the axis of each cylindrical aperture is positioned equidistant from the outer edge of the first finned heat sink and from the outer edge of the second finned heat sink.

The axis of the or each cylindrical aperture is the segment containing the centre of the two bases of the cylinder.

Preferably, the cooling module is substantially symmetrical about a rotational axis of symmetry positioned along its midline.

It is understood that in the context of this invention, "symmetrical" refers to the shape and configuration of the first finned heat sink being the same as the shape and configuration of the second finned heat sink. That is, in use the first finned heat sink could take the place of the second finned heat sink if it were rotated by 180-degrees.

Preferably, the fins of the first finned heat sink are aligned to be symmetrical with the fins of the second heat sink about the midline of the cooling module.

Preferably, the first and second finned heat sink each comprise an array of fins wherein each fin is equidistant from an adjacent fin.

Preferably, the first finned heat sink is removably secured proximal to the second finned heat sink by at least one locking member, wherein the or each locking member brings the first finned heat sink into locking engagement with the second finned heat sink. More preferably, the first finned heat sink is removably secured proximal to the second finned heat sink by at least two locking members, wherein the or each locking member brings the first finned heat sink into locking engagement with the second finned heat sink.

Preferably, the or each locking member is spaced apart from the or each fin of the first finned heat sink and the or each fin of the second finned heat sink.

Preferably, the first finned heat sink comprises at least one locking tab for interlocking with at least one locking tab on the second finned heat sink.

More preferably, the first finned heat sink comprises at least two locking tabs for interlocking with at least two locking tabs on the second finned heat sink.

The present invention ensures that the force exerted on the thermal transfer member/s (metal rod/s or heat pipe/s) by the first finned heat sink is equal to the force exerted on the thermal transfer member/s (metal rod/s or heat pipe/s) by the second finned heat sink.

It is understood that "interlocking" refers to component parts that, in use, mechanically connect and fit together so that movement of the connected parts is constrained.

Preferably, the or each locking tab is L-shaped or U shaped.

Preferably, movement of the first finned heat sink away from the second finned heat sink moves the or each locking tab of the second finned heat sink into an interlocking configuration.

Preferably, when the or each locking tab of the first finned heat sink and the or each locking tab of the second finned heat sink are interlocked, further movement of the first finned heat sink away from the second finned heat sink is restricted.

Preferably, when the or each locking tab of the first finned heat sink and the or each locking tab of the second finned heat sink are interlocked, the first finned heat sink is spaced apart from the second finned heat sink.

More preferably, when the or each locking tab of the first finned heat sink and the or each locking tab of the second finned heat sink are interlocked, the first finned heat sink is spaced apart from the second finned heat sink by about 2mm.

Preferably, the first finned heat sink and the second finned heat sink are secured to the or each heat pipe with a gap between each heat pipe and the substantially cylindrical aperture into which it is received of less than or equal to about 1mm.

Preferably, the or each locking member comprises a tension pin or a resilient pin or a spring pin or a screw, such as a threaded screw, insertable between the at least one locking tab of the first finned heat sink and the at least one locking tab of the second finned heat sink.

Preferably, insertion of the or each locking member between the at least one locking tab of the first finned heat sink and the at least one locking tab of the second finned heat sink prevents movement of the first finned heat sink away from the second finned heat sink.

Preferably, insertion of the or each locking member between the at least one locking tab of the first finned heat sink and the at least one locking tab of the second finned heat sink locks the first finned heat sink in position spaced apart from the second finned heat sink.

The locking member of the present invention allows the cooling module to be locked in position without the use of additional tooling or fixings.

Preferably, the or each locking member is inserted such that its length is parallel to the length of the or each aperture.

Preferably, each locking member is insertable between the at least one locking tab of the first finned heat sink and the at least one locking tab of the second finned heat sink to lock the locking tabs together in a locked configuration.

Preferably, the locking member further comprises at least one stop at a first end.

Preferably, the locking member is tapered at a second end.

Preferably, the locking tabs are immovable in a locked configuration.

Preferably, the first finned heat sink and the second finned heat sink are aluminium. Optionally, the first finned heat sink and the second finned heat sink are copper.

In a further aspect the invention provides an LED curing apparatus comprising:
an LED array comprising a plurality of LEDs mounted on an LED heat sink;
at least one cooling module as previously described secured around one or more thermal transfer member, wherein a first end of the or each thermal transfer member is proximal to the LED array and a second end of the or each thermal transfer member is held substantially within the at least one cooling module.

Preferably, the or each thermal transfer member is a metal rod.

Optionally, the or each thermal transfer member is a heat pipe. Preferably, wherein the evaporator section of the or each heat pipe is proximal to the LED array and the condenser section of the or each heat pipe is held substantially within the at least one cooling module.

Preferably, the LED curing apparatus is for printing and coating applications.

Preferably, the at least one cooling module is locked to the or each thermal transfer member by insertion of at least one locking member; more preferably, the at least one cooling module is locked to the or each thermal transfer member by insertion of at least two locking members.

The use of at least two locking members has been found to be advantageous in preventing any twisting of the first and second finned heat sinks within the cooling module.

Preferably, wherein the or each locking member is inserted into the surface of the or each cooling module that is furthest from the LED array.

Preferably, the LED curing apparatus is air cooled and comprises at least one inlet through which cool air enters the LED curing apparatus and at least one outlet through which heated air leaves the LED curing apparatus.

Preferably, the LED curing apparatus comprises a plurality of cooling modules along the length of the LED curing apparatus.

The "length" is understood to refer to the greatest of the three dimensions of the LED curing apparatus.

In a further aspect, the present invention provides a method of installation of at least one cooling module into an LED curing apparatus, comprising a plurality of thermal transfer members:
removably securing a first finned heat sink to a second finned heat sink to provide at least one aperture therebetween, wherein a thermal transfer member is held within each of the at least one apertures;
adjusting the position of the or each thermal transfer members;
locking the first finned heat sink to the second finned heat sink by insertion of at least one locking member to form a cooling module;
attaching the cooling module to an LED heat sink supporting an LED array.

Preferably, the or each thermal transfer member is a metal rod.

Preferably, the or each thermal transfer member is a heat pipe.

Preferably, the at least one cooling module is a cooling module as described herein.

Preferably, the or each locking member is an elongate locking member; more preferably, the or each locking member is an elongate pin or a screw or a threaded screw, that is inserted such that its length is parallel to the length of the or each aperture.

Preferably, the method of installation further comprises applying a thermal transfer material to the at least one aperture.

More preferably, the thermal transfer material is a thermal transfer paste.

In a further aspect, the invention provides an LED curing apparatus comprising:
at least one LED radiation source mounted on an LED mount;
a housing comprising at least one air inlet;
at least one finned heat sink;
at least one air passage through the housing from the or each air inlet through the or each finned heat sink to at least one air outlet;
wherein the housing comprises an inlet cavity below the or each finned heat sink and an outlet cavity above the or each finned heat sink to maintain a higher air pressure below the or each finned heat sink and a lower air pressure above the or each finned heat sink.

It is understood that "below" the or each finned heat sink refers to the direction towards the LED-mounting/substrate-facing surface of the LED curing apparatus. It is understood that "above" the or each finned heat sink refers to the direction opposing the LED-mounting/substrate-facing surface of the LED curing apparatus.

Preferably, the LED curing apparatus further comprises a source of air and the air pressure in the inlet cavity below the or each finned heat sink is higher than the air pressure in the outlet cavity above the or each finned heat sink to cause suction of air along the or each air passage through the housing from the or each inlet to the or each air outlet through the or each finned heat sink.

Preferably, air is pulled out of the housing through the or each air outlet and pulled into the housing through the or each air inlet.

Preferably, the LED curing apparatus comprises a source of air and the air pressure decreases from the at least one air inlet to the inlet cavity and decreases further from the inlet cavity to the outlet cavity and decreases further again from the outlet cavity to the or each air outlet.

Optionally, the invention provides an LED curing apparatus comprising:
at least one LED radiation source mounted on an LED mount;
a housing comprising at least one air inlet at a first end of the apparatus; at least one finned heat sink; and
at least one air passage within the housing from the air inlet through the or each finned heat sink to at least one air outlet;
wherein the housing comprises a cavity to maintain a higher air pressure proximal to the LED mount than the air pressure within the or each finned heat sink.

Preferably, the housing is cuboidal.

Preferably, the LED curing apparatus comprises a plurality of LEDs in a linear array.

Preferably, wherein the air passage comprises at least one restriction proximal to the or each finned heat sink.

Preferably, wherein the air passage comprises at least one restriction proximal to the or each finned heat sink and at least one further restriction proximal to the at least one air outlet.

Preferably, wherein the air passage comprises at least one restriction below the or each finned heat sink.

More preferably, the restriction below the or each finned heat sink reduces the cross sectional area of the air flow path from the inlet cavity below the or each heat sink to the or finned heat sink.

Preferably, the reduction in the cross sectional area of the air flow path from the inlet cavity below the or each finned heat sink to the or each finned heat sink is by a ratio of between 1:2 to 1:3 (inlet cavity:finned heat sink); more preferably, the reduction in the cross sectional area of the air flow path from the cavity below the or each finned heat sink to the or each finned heat sink is by a ratio of 2:5 (inlet cavity: finned heat sink); most preferably, the reduction in the cross sectional area of the air flow path from the cavity below the or each finned heat sink to the or each finned heat sink is by a ratio of 1:2.3 (inlet cavity: finned heat sink).

Preferably, the LED curing apparatus further comprises at least one source of cool air and at least one fan to move air into the or each air passage.

Optionally, the LED curing apparatus further comprises at least one source of cool air and at least one fan to blow air into the or each air passage.

Optionally, the LED curing apparatus comprises at least one source of cool air and a plurality of fans.

Preferably, the LED curing apparatus comprises at least one source of a cool air and at least one fan positioned at a distance from the LED curing apparatus; more preferably, the LED curing apparatus further comprises ducting wherein the or each fan is connected to the LED curing apparatus by the ducting.

Preferably, the at least one air inlet is at a first end of the apparatus and the opposing second end of the apparatus is sealed.

Preferably, the or each LED radiation source is arranged at the base of the apparatus.

Preferably, the first end of the apparatus is substantially perpendicular to the base of the apparatus.

Preferably, the at least one air outlet comprises an elongate opening.

Preferably, the at least one air outlet comprises an outlet in the upper face of the apparatus.

It is understood that in the context of this invention, the "base of the apparatus" is the substrate-facing surface with the or each LED radiation source arranged thereon. The upper face of the apparatus is substantially parallel to and spaced apart from the base of the apparatus.

Preferably, wherein the air pressure at or near the LED mount is greater than air pressure at or near to the finned heat sink.

Preferably, the pressure difference between the inlet cavity and the outlet cavity exceeds between about 150Pa and 400Pa along the length of the LED curing apparatus; more preferably, the pressure difference between the inlet cavity and the outlet cavity exceeds between about 150Pa and 300Pa along the length of the LED curing apparatus; most preferably, the pressure difference between the inlet cavity and the outlet cavity exceeds about 150Pa along the length of the LED curing apparatus.

Preferably, the air pressure in the inlet cavity proximal to the or each finned heat sink is between about -310Pa and -610Pa relative to atmospheric pressure.

Preferably, the air pressure in the or each outlet cavity is between about -1150Pa and -650Pa relative to atmospheric pressure.

Preferably, the or each finned heat sink comprises at least one air inlet through which air enters from the housing into the finned heat sink.

Preferably, the ambient absolute temperature of air along the length of the LED curing apparatus is substantially uniform.

It is understood that "length" refers to the longest dimension of the LED curing apparatus.

Preferably, the dimensions of the air inlet of the or each finned heat sink restricts the air flow through the inlet.

Preferably, the LED curing apparatus comprises at least one thermal transfer member.

Preferably, the LED curing apparatus comprises at least one heat pipe.

Optionally, the LED curing apparatus comprises at least one metal rod or at least one metal pipe. Preferably, the LED curing apparatus comprises a plurality of heat pipes.

Preferably, the LED curing apparatus comprises a plurality of metal pipes.

For the purposes of clarity and a concise description, features are described herein as part of the same or separate embodiments; however, it will be appreciated that the scope of the invention may include embodiments having combinations of all or some of the features described.

The invention will now be described by way of example with reference to the accompanying drawings, in which: -
Figure 1 is a cross-sectional view through a cooling system for an LED print curing apparatus in accordance with the present invention;
Figure 2a is a perspective view of the thermal transfer member and collar shown in Figure 1;
Figure 2b is a perspective view of an alternative embodiment of the thermal transfer member and collar of the present invention;
Figure 3 is a cross-sectional view of the heat pipe and collar shown in Figure 2a;
Figure 4a shows a perspective view of a cooling module for an LED curing apparatus;
Figure 4b shows a perspective view of a further embodiment of the cooling module for an LED curing apparatus;
Figure 5 shows a side view of a cooling module for an LED curing apparatus as shown in Figure 4a;
Figure 6 shows a view from above of a finned heat sink;
Figure 7a shows a view from above of a first finned heat sink interlocking with a second finned heat sink (heat pipes not shown) in a maintenance or assembly configuration;
Figure 7b shows a view from above of a first finned heat sink locked to a second finned heat sink (heat pipes not shown) in a use configuration;

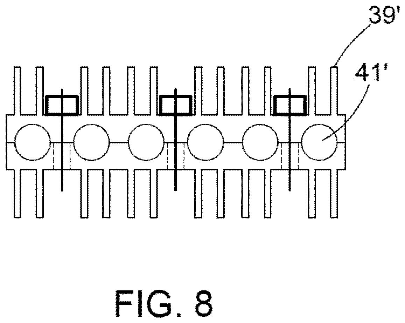

Figure 8 shows a view from above of a first finned heat sink locked to a second finned heat sink (heat pipes not shown) in a use configuration in an alternative to the present invention;
Figure 9 shows a cross section through an LED curing apparatus and the air flow path therethrough for a preferred embodiment wherein air is pulled through the LED curing apparatus;
Figure 10 shows a perspective external view of the LED curing apparatus of the Figure 9 showing the direction of air flow through the apparatus;
Figures 11 shows a cross section through an LED curing apparatus and the air flow path therethrough for an embodiment wherein air is blown through the LED curing apparatus; and
Figure 12 shows a perspective external view of the LED curing apparatus of

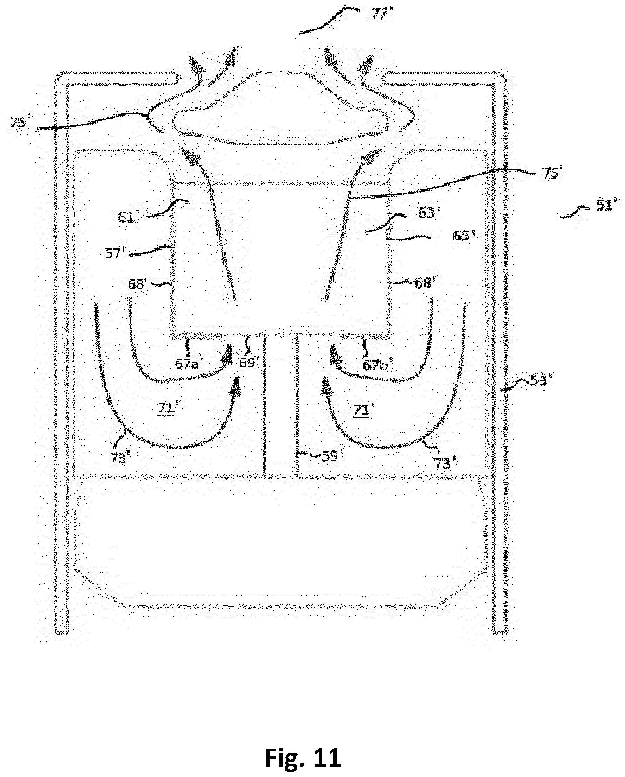

Figure 11 showing the direction of air flow through the apparatus.

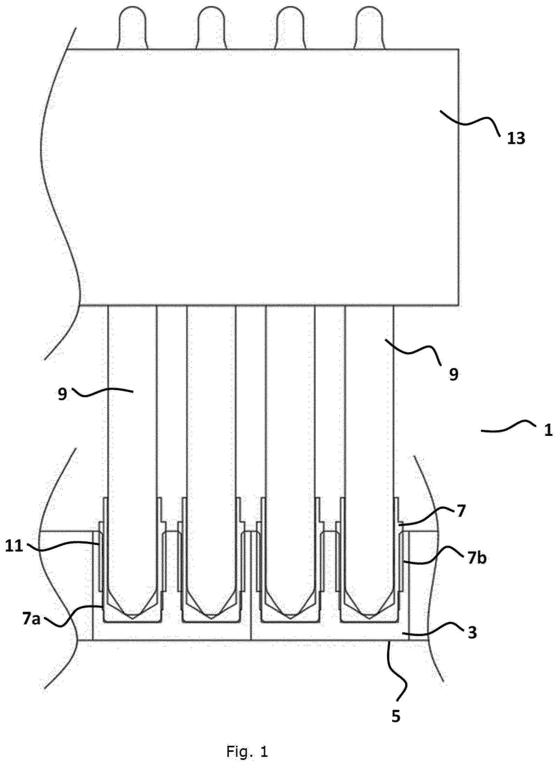

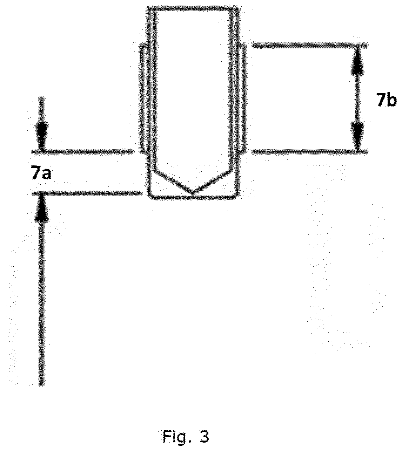

Referring to Figures 1 and 3, the present invention relates to a cooling system 1 for an LED print curing apparatus. The cooling system 1 comprises an LED mount 3. In use a plurality of LEDs 5 are mounted on the LED mount 3. In use, the LEDs are arranged to emit radiation from an outer, substrate-facing side. The cooling system 1 supports a plurality of thermal transfer members, such as a metal rods or copper heat pipes 9, wherein the heat pipes 9 or metal rods sit within the body of the LED mount 3 and transfer heat away from the LEDs 5 to a cooling module 13.

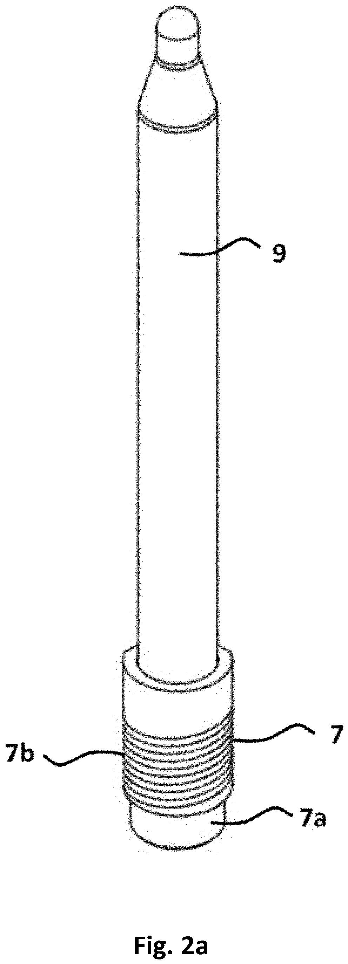

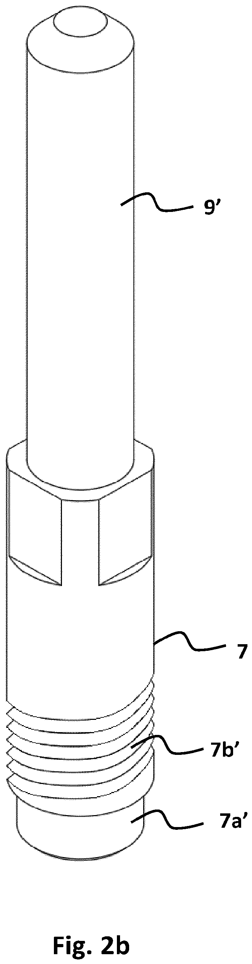

The cooling system 1 comprises an aluminium LED mount 3, which carries heat generated by the LEDs 5 away from the LEDs 5 to the thermal transfer members, shown in Figure 1 as copper heat pipes 9. The dimensions of the aluminium heat sink 3 are carefully configured to be fitted within the lamphead of a curing apparatus (not shown). The cooling system 1 comprising the LED mount 3, LEDs 5 and heat pipes 9 form a modular system. In use, multiple cooling systems 1 are arranged along the length of a curing apparatus. The plurality of heat pipes 9 are a passive heat transfer system to efficiently carry heat away from the LEDs 5. In one embodiment of the present invention, the modular system comprises two heat pipes 9 per length of LED mount 3. It is understood that in further embodiments, an alternative thermal transfer member rather than the heat pipe shown in Figures 1 and 3 is used; for example, a metal rod.
With reference to Figure 1 and Figure 2a and Figure 2b, each of the thermal transfer members/copper heat pipes 9, 9' are provided with a copper collar 7, 7' which is soldered to the thermal transfer members, such as the copper heat pipes 9 shown in Figure 2a or the metal rod shown in Figure 2b. The collar 7, 7' includes a screw thread 7b, 7b' on a substantial portion of an outer surface thereof and a smooth, non-threaded portion 7a. The LED mount 3 comprises a series of substantially cylindrical bores 11, which have a threaded inner surface for engagement with the corresponding screw thread 7b, 7b' on the outer surface of a copper collar 7, 7'. This allows the heat pipes 9 or thermal transfer members, such as metal rods 9' to be screwed into the bores 11 in the LED mount 3 for secure attachment thereto Referring to Figure 2a, the collar surrounding the evaporator section of the heat pipe so that each heat pipe 9 is fully contained within the LED mount 3 when fitted to the cooling system 1 . In use, this allows the LEDs 5 to be mounted to the LED mount 3 before the heat pipes 9 are each fitted into a respective bore 11. The collar shown in Figure 2b is surrounding a first end of the metal rod/thermal transfer member 9' so that when attached each metal rod/thermal transfer member 9' is fully contained within the LED mount 33 when fitted to the cooling system 1 In use, this allows the LEDs 5 to be mounted to the LED mount 3 before the thermal transfer members/metal rods/heat pipes 39', 39 are each fitted into a respective bore 41.

Referring to Figure 2b, the collar 7' and metal rod 9' are formed as a single piece. This improves thermal transfer and reduces the time and complexity of installation.

The present invention, shown in Figures 1, 2a, 2b and 3 significantly improves the ease of installation of the thermal transfer members/heat pipes 9', 9 within a curing apparatus. In use, the LEDs 5 are attached to the LED mount 3 and the thermal transfer members/heat pipes 9', 9 are attached at a later stage. This minimises the installation time in a clean room because only the LEDs need to be installed in this controlled environment, whilst other components of the cooling system can be installed at the location of use of the apparatus. Multiple LED mounts 3 having LEDs 5 attached thereto are installed in the chassis of a curing apparatus before the thermal transfer members/heat pipes 9', 9 are screwed into the LED mount 3 and attached thereto by the mating engagement of the screw thread 7b on the outer surface of the collar 7 with the threaded inner surface of the bore 11 into which the thermal transfer members/heat pipe 9', 9 is received. The present invention allows for ease of assembly of the LED mounts 3 into the curing apparatus before the thermal transfer members/heat pipes 9', 9 and further cooling components are installed. Furthermore, the thermal transfer members/heat pipes 9', 9 and other cooling components can be removed and replaced; for example, if these components fail or require cleaning, without the sealed chassis of the apparatus containing the LEDS being removed. Removal of the LEDS is more likely to damage the delicate LEDs. The present invention significantly reduces the risk of damage or contamination of the LEDs.

A ceramic paste (not shown) is provided between the outer surface of each of the heat pipe collars 7', 7 and the respective inner surface of the bore 11 in which the thermal transfer members/heat pipe 9', 9 is held. The ceramic paste prevents voids forming between the collar 7', 7 and the bore 11, which ensures optimum thermal contact between the LED mount 3 and the thermal transfer members/heat pipes 9', 9 because there are no thermal barriers to the heat transfer away from the LED mount 3 and so away from the LEDs 5, in use.

In the example shown in which corresponding screw threads 7b, 7b' are provided on the external surface of the collar 7, 7' and the internal surface of the bore 11, it will be appreciated that the ceramic paste can be applied to one or both threaded surfaces before the thermal transfer members/heat pipes 9', 9 are screwed into the LED mount 3. During installation, the rotation of the external threaded surface of the collar 7, 7' against the internal threaded surface of the bore 11 spreads the ceramic paste so that any voids are eliminated.

Referring to Figures 1 and 2a, in use, the central core of each heat pipe 9 contains a liquid, such as water or ammonia, which prior to heating is held by a wick structure (not shown). The heat pipe 9 contains a vacuum so that the liquid will boil and take up heat generated by the LEDs 5 at a temperature below the boiling point of the liquid at atmospheric pressure. The water will boil and effectively transfer latent heat from the LEDs 5 modules at this lower temperature. In use, when the LED print curing apparatus is switched on and the LEDs 5 are radiating to cure a substrate, heat generated by the LEDs 5 is transferred away from the rear, inner face of the LEDs 5 to the LED mount 3. Heat is carried away from the LED mount 3 by the heat pipe/s 9 to a cooling module 13. On heating, the liquid held within the core of the heat pipe 9 is vaporised and the heat is carried away before the liquid re-condenses and the wick transports the liquid back to the base of the heat pipe 9. The heat pipe/s 9 ensures that heat is carried away quickly and efficiently from the LEDs 5 and condensation of the liquid contained within the core of the heat pipe 9 is enhanced by capillary action.

As shown with particular reference to Figure 2a, 2b and Figure 3, in order to increase the contact surface area of the collars 7, 7' and the bores 11, the outer walls of the collars are shaped to fit against correspondingly shaped walls of the bores 11. Each collar 7, 7' has a smooth, rounded base section 7a, 7a' which is received into a bore 11. The mechanical fit of the threaded portion 7b, 7b'with the threaded portion of the bore 11 in addition to the heat transfer material (not shown) between the external surface of the collar 7/heat pipe 9 shown in Figure 2a or the collar 7'/metal rod 9' and the internal surface of the bore 11 ensures that there are no voids such that thermal transfer is optimised.

As shown in Figure 1, the evaporator section of each thermal transfer member/heat pipe 9 is adjacent to the LED mount 3 and the LEDs 5 that are mounted thereon. The opposing end - i.e., the condenser end of each heat pipe 9 is held within a cooling module 13. In a preferred embodiment, the cooling module 13 is an air-cooled finned heat sink.

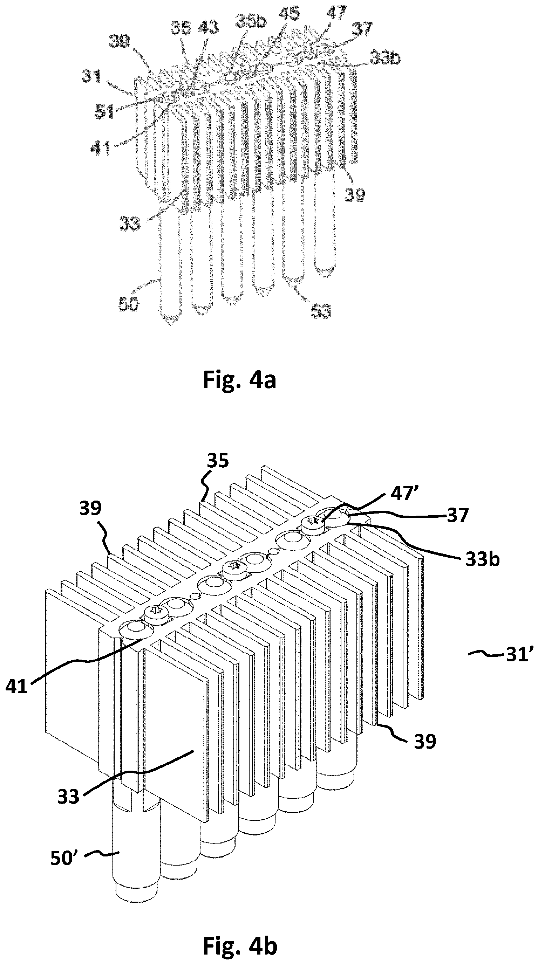

Referring to Figures 4a and 4b, Figure 5 and Figure 6, a cooling module 31 is shown and comprises a first finned heat sink 33, 33' and a second finned heat sink 35, 35'. The first finned heat sink 33, 33' is substantially symmetrical to the second finned heat sink 35, 35' about a central axis 37 or midline where the internal surface 33a of the first heat finned sink 33 is proximal to and spaced apart from the internal surface of the second heat finned sink 35. Each finned heat sink 33, 35 is an aluminium extrusion and is shaped to maximise heat transfer away from the heat sink 33, 35 through a plurality of fins 39, which are substantially cuboidal, and each fin protrudes perpendicular to the central axis 37. The plurality of fins 39 are equally spaced from each other so that each fin 39 is spaced from the adjacent fin 39 by a uniform distance. For example, each fin 39 has a width of about between about 1.5mm and 5mm and is spaced from the adjacent fin 39. In a preferred embodiment, the fin 39 has a width of about 1.5mm at its tip with a width increasing towards the midline of the fin with a pitch of 3.5mm.

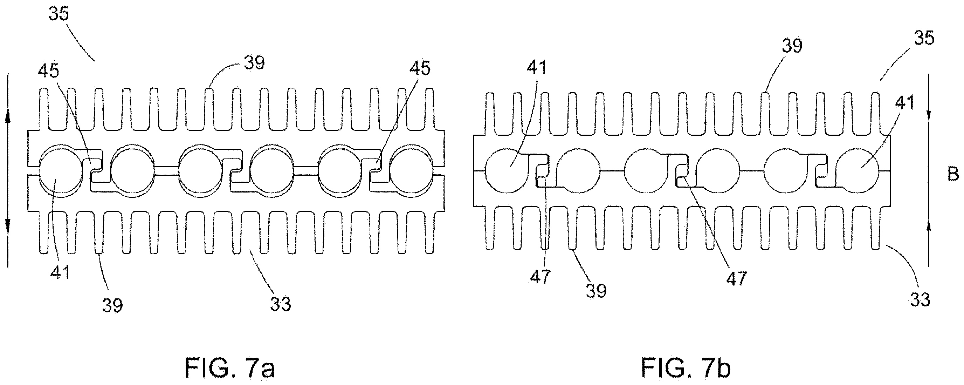

Referring to Figures 4, 4b and Figure 7, the internal surface 33a of the first finned heat sink 33 comprises a series of semi-cylindrical recesses 33b. The internal surface (not shown) of the second finned heat sink 35 also comprises a series of semi-cylindrical recesses 35b and is symmetrical about the central axis 37 where the internal surface 33a of the first finned heat sink 33 is proximal to the internal surface 35a of the second finned heat sink 35. That is, each of the recesses 33b, 35b have the shape of a longitudinal half of a cylinder. As shown in Figures 4a and 4b, when the first finned heat sink 33 is removably secured to the second finned heat sink 35 the internal face of the first heat sink 33a is spaced apart from the internal face of the second heat sink 35a so that a plurality of substantially cylindrical recesses 41 are formed therebetween.

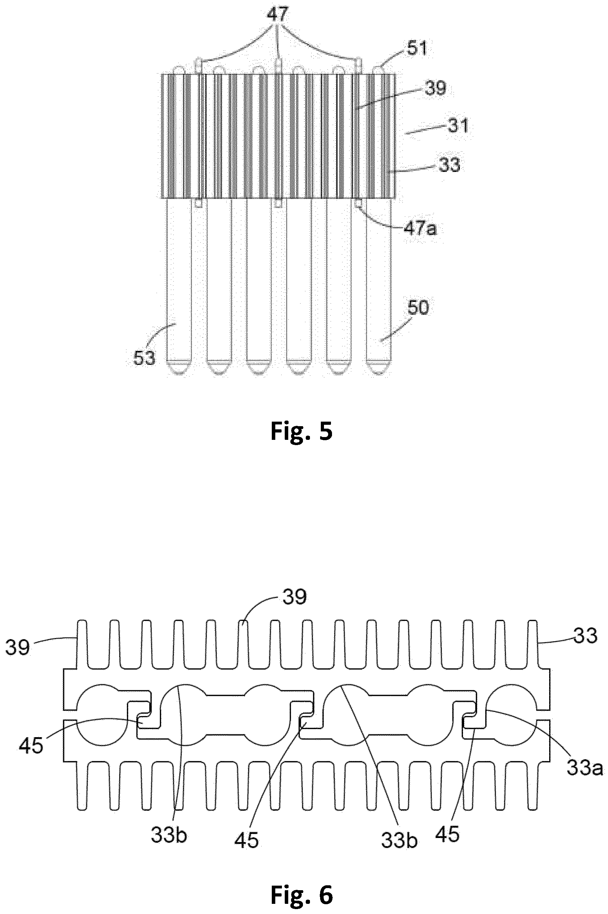

Referring to Figures 4a, Figure 4b, and Figure 5, in a use configuration, the cooling module 31 is secured to a plurality of thermal transfer members, shown as heat pipes 50. In alternative embodiments, the cooling module is secured to a plurality of thermal transfer members; for example, a metal rod or a metal pipes, such as a copper rod or a copper pipe. A heat pipe 50 is received in each of the cylindrical recesses 41. Each heat pipe 50 is held securely within the cooling module 31 to ensure optimum thermal contact between the condenser section of the heat pipe 50 and the cylindrical recess 41 into which the heat pipe is received. The heat pipes 50 secure the first and second finned heat sinks 33, 35 of the cooling module 31 in a tight clamping arrangement. The semi-cylindrical recesses 33b, 35b are substantially the same radius as the outer radius of the heat pipe 50. For example, each heat pipe has a radius of about 4mm and the cylindrical aperture formed by the semi-cylindrical recesses 33b, 35b have a radius of about 4mm. This ensures that each heat pipe 50 is firmly held in place and that the heat transfer is as efficient as possible from each heat pipe 50 to the surrounding finned heat sink 33, 35. This maximises the heat transfer away from each heat pipe 50 to the fins 39 of each heat sink 33, 35.

Referring to Figures 6, 7a and 7b, each finned heat sink 33, 35 comprises an interlocking tab 45. In the embodiment shown in Figure 6, the interlocking tab 45 is substantially L-shaped.

Referring to Figure 7a, in a maintenance configuration, each of the plurality of thermal transfer members, such as heat pipes or metal rods (not shown) are located and held within a cylindrical recesses 41 between the first finned heat sink 33 and the second finned heat sink 35. The tab 45 of the first finned heat sink 33 interlocks with the tab 45 of the second heat sink 35 so that the cooling module 31 is held around the thermal transfer members/heat pipes but can be adjusted to allow for ease of insertion of multiple thermal transfer members/heat pipes into the cooling module. The interlocking tabs 45 stay linked whilst allowing partial movement of the first finned heat sink 33 and the second finned heat sink 35 around the thermal transfer members/heat pipes. In this maintenance configuration there is a small gap between the tab 45 of the first finned heat sink 33 that is interlocked to abut with the tab 45 of the second heat sink 35.

For installation of the cooling module, the thermal transfer members/heat pipes/metal rods 50 are first fitted to an LED heat sink on which LEDs are mounted. A carefully measured dose of heat transfer paste is applied to the semi-cylindrical recesses 33b, 35b of both the first finned heat sink 33 and the second finned heat sink 35. The first finned heat sink 33 and the second finned heat sink 35 are then interlocked as far as the interlocking tabs 45 allow. The interlocked finned heat sinks 33, 35 are then precisely lowered over and around the heat pipes 50. The first finned heat sink 33 is spaced apart from the second finned heat sink 35 when they are brought together to form the cylindrical apertures. The first finned heat sink 33 and the second finned heat sink 35 are mechanically clamped together by the interlocking tabs 45 for ease of installation.

Referring to Figure 7b, when all of the required thermal transfer members/heat pipes (not shown) are held in the desired position a locking pin 47 is inserted into the or each small gap between the tab 45 of the first finned heat sink 33 that is interlocked with the tab 45 of the second heat sink 35. In this final stage of installation, insertion of the locking pin 47 releases the mechanical clamp between the interlocking tabs 45 to transfer the locking force to the or each locking pin 47. The locking pin 47 is a tension pin or a spring pin. Referring to Figure 4b, in an alternative embodiment a screw 17', for example, a threaded screw, is inserted into the or each small gap between the tab (not shown) of the first finned heat sink 3 that is interlocked with the tab (not shown) of the second finned heat sink 5.

Referring to Figure 7b and 6, insertion of a locking pin 47 in a direction parallel to the axis of the cylindrical recess 41 forces the tab 45 of the first finned heat sink 33 into locking engagement with the tab 45 of the second finned heat sink 35. Thus, each thermal transfer member, shown as heat pipe 50 is held securely with the cylindrical recess 41 in the cooling module 31 so that the condenser section is held against the finned heat sinks 33, 35 for optimum thermal transfer of heat from the heat pipe 50 to the fins 39.

Referring to Figure 5, the evaporator section of each of the heat pipes 50 protrudes from the base of the cooling module 31 to be secured proximal to the LED heat sink in the lamphead.

Referring to Figures 7a and 7b, in a maintenance position without the locking pin or screw inserted, the first and second finned heat sinks 33, 35 can move in a direction shown by arrow A towards and away from a heat pipe/s contained between them in the cylindrical recesses. Referring to Figure 7b, when the locking pin 47, or in alternative embodiments a screw, is inserted, in a use position, the first and second finned heat sinks 33, 35 are forced towards each other in a direction shown by arrow B so that their internal surfaces are proximal to each other and are locked in position.

In use with an LED curing apparatus, a plurality of cooling modules are arranged along the length of the LED curing apparatus around a plurality of thermal transfer members, for example heat pipes or metal rods. The cooling modules have a length of about 25mm and are arranged substantially along the full length of the lamphead and are locked in place by the locking pins. For known devices, the thermal transfer members, for example heat pipes or metal rods are spaced at increments of about 2.5cm for a range of lengths from 2.5cm to 250cm. The cooling modules are configured so that the cooling modules can be conveniently installed on site; for example, during an on-site repair. The cooling modules can be fixed to the thermal transfer members, for example heat pipes or metal rods, after the LEDs are attached to the LED heat sink.

The lamphead comprises an array of LED modules (not shown), wherein each LED module is a unit containing one or more LEDs. In use, each LED is a radiation source for curing print or a coating on a substrate (not shown). It is understood that the LED modules form a linear radiation source to direct radiation continually onto a substrate during curing. The LED modules comprise boards that rest on a heat sink (not shown). This LED heat sink is adjacent to the evaporator section of each of the plurality of heat pipes.

In use, the LEDs are arranged to emit radiation from an outer, substrate-facing side through a "curing window" onto a substrate (not shown) to be cured. In alternative embodiments, the "curing window" comprises a lens or reflector. The lamphead is an elongate shape and can be fitted directly onto a machine, or is a slideable cuboidal cassette which, in use, is slideable into a housing. When inserted into the housing, the LED modules form a solid radiation emitting face.

Referring to Figures 4a and 5 in use, heat is transferred away from the inner face of the LED modules to the evaporator section of the heat pipes 50. Heat is carried from the evaporator section of each heat pipe 50 to the condenser section that is held substantially within the cooling module 31. Heat is then efficiently transferred though the first and second finned heat sink 33, 35 so that the LEDs are rapidly and efficiently cooled. Furthermore, the configuration of the present invention ensures that the cooling modules 31 hold the heat pipes 50 in place, achieving good thermal contact between the finned heat sinks 33, 35 and the heat pipes 50, wherein the clamping force between the heat sinks 33, 35 and the heat pipes 50 is uniform along the length of the cooling module 31.

The heat pipes 50 of the present invention use known heat pipe technology to take up heat generated by the LED modules (not shown). In use, when the lamphead is switched on and the LEDs are radiating to cure a substrate, heat generated by the LEDs is transferred away from the rear, inner face of each LED module to an aluminium heat sink (not shown). Heat is carried away from the LEDs and the copper heat sink by the heat pipe/s 50 and is then carried away from the heat pipes 50 by the first and second finned heat sinks 33, 35. On heating, the liquid held within the core of the heat pipe 50 is vaporised and the heat is carried away before the liquid re-condenses and a wick transports the liquid back to the base of the heat pipe 50. Heat is rapidly transferred from the LED modules to the heat pipes 50 and to the cooling modules.

Referring to Figure 4a and Figure 4b, to access the thermal transfer members 50, 50' for maintenance or repair, the pins 47 or screws 47' securing the cooling module 31 around the heat pipes 50 are removed. With the pins 47 removed, the first finned heat sink 33 is able to move away from the second finned heat sink 35 increasing the size of the cylindrical recesses and allowing the cooling module 31 to be removed from the heat pipes 50. Movement of the first finned heat sink 33 and second finned heat sink 35 away from each other causes the locking tabs 43, 45 to move into an interlocking position. This maintains the first finned heat sink 33 interlocked with the second finned heat sink 35 so that the components of the cooling module 31 remain assembled when the cooling module is in a maintenance configuration. The cooling module 31 can then be removed from the thermal transfer members; i.e. the heat pipes 50 shown in Figure 4a and the metal rods shown in Figure 4b, if required.

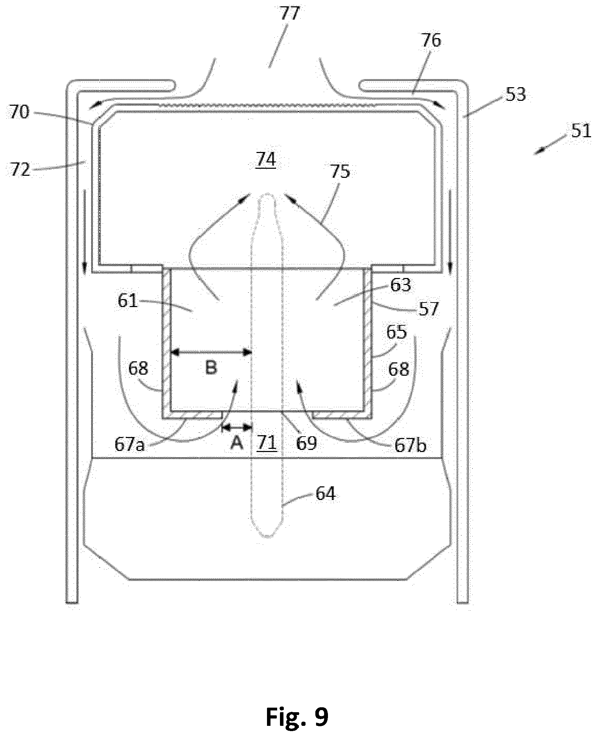

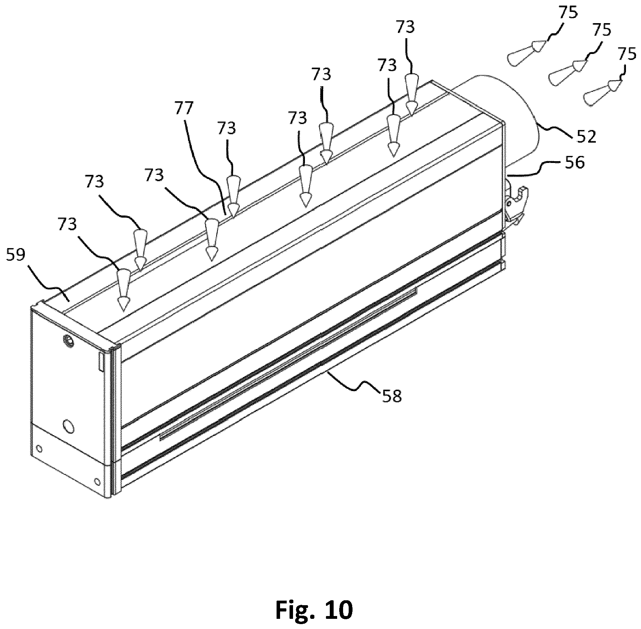

Referring to Figures 9 and 10, an LED curing apparatus 51 is shown comprising a housing 53. The housing 53 comprises an outer casing wherein LEDs (not shown) are mounted at the base 58 of the housing 53 and an air inlet 77 is positioned in an upper face 59 of the housing 53. The air inlet 77 is an elongate opening along substantially the entire length of the upper face of the apparatus 51. The base 58 of the LED curing apparatus 51 is the substrate-facing surface with the or each LED radiation source arranged thereon. In a preferred embodiment, the LED radiation source is a UV radiation source. In alternative embodiments, the LED radiation source is an infra-red radiation source. The upper face of the apparatus 51 is substantially parallel to and spaced apart from the base of the apparatus 51. An air outlet 52 is positioned at a first end 56 of the apparatus 51, wherein the first end 56 is perpendicular to and between the base 58 and the upper face 59 of the apparatus 51. The air outlet 52 is attached to ducting connected to a source of ambient or cooled air.
The LED curing apparatus 51 comprises a plurality of LEDs (not shown) mounted to an LED mount. The inner walls of the housing 53 and the cavities formed therein are shaped to control air pressure and air flow through the LED curing apparatus 51. The housing 53 is substantially cuboidal comprising outer walls 53 and inner walls 70 to which further components are mounted. The shape of the inner walls of the housing 53 controls air pressure and so air flow through the device.

Referring to Figure 9, an inner wall of the housing 70 defines an upper air channel 72 through which air from the air inlet 77 passes into the curing apparatus 51. The upper air channel 72 is parallel to the outer walls 53 of the housing. Preferably, the width of the upper air channel 72 is about 4mm. The upper air channel 72 increases in width to about 10mm and passes from the air inlet 77 to an inlet cavity or void 71.

A plurality of thermal transfer members, shown in Figures 9 and 10 to be heat pipes 14, are mounted along the length of the LED curing apparatus 1. In alternative embodiments, an alternative thermal transfer member is used; for example, as shown in Figure 1b, the thermal transfer member is a metal rod. In the embodiment shown in Figure 9, each heat pipe 64 is held securely within a cooling module 57, ensuring optimum thermal contact between the heat pipe 64 and a substantially cylindrical recess into which each heat pipe is received. The or each thermal transfer member/ heat pipe 64 passes through the inlet cavity or void 71 of the housing 53. The cooling module 57 comprises a first finned heat sink 61 and a second finned heat sink 63. The first finned heat sink 61 is substantially symmetrical to the second finned heat sink 63 about a central axis or midline. Each finned heat sink 61, 63 is shaped to maximise heat transfer away from the heat sink 61, 63 through a plurality of fins (not shown), which are substantially cuboidal. In alternative embodiments, it is understood that equivalent heat sinks could be used. For example, an arrangement of pins or blades could be used, including a skived heat sink. It is also envisaged that alternative configurations of the present invention include finned heat sinks in alternative positions to carry heat away from the thermal transfer members, which are either heat pipes or metal rods. The inner walls of the housing 53 define a main cavity or void 71 below the or each finned heat sink 61, 63 and a second cavity or outlet void 74 above the or each finned heat sink 61, 63 through which heated air 75 exits the LED curing apparatus 51. For example, the cross-sectional area of the air path through the outlet void 74 is about 1.2 times greater than the cross-sectional area of the air path through the inlet void 71.

The first finned heat sink 61 and the second finned heat sink 63 are removably held within the housing 53 by a shaped extrusion 65 comprising a base 67a, 67b and two upstanding walls 68. The base 67a, 67b and upstanding walls 68 are formed of a shaped extrusion, wherein each upstanding wall 68 is substantially perpendicular to the base 67a, 67b and held within the outer walls of the housing 53. The base 67 comprises a first base member 67a and a second base member 67b, which are substantially parallel to the LED mount. The first and second base members 67a, 67b partially cover the base of the respective finned heat sink 61, 63. The first finned heat sink 61 is housed above the first base member 67a and the second finned heat sink 63 is housed above the second base member 67b. The base members 67a, 67b are spaced apart from each other to form a restriction in the air flow through a gap therebetween to provide an air inlet 69 into the finned heat sinks 61, 63 through which air is pulled.

Referring to Figures 9 and 10, air 77 is pulled into the apparatus by a source of air connected by ducting to the outlet 52. Typically, the air pressure at the outlet ducting is about -2050Pa relative to ambient pressure and the pressure of air drawn into the air inlet 77 is between about -350Pa to -500Pa relative to ambient pressure. The air pressure is higher at the inlet 77 to the apparatus to create suction so that air is pulled through the apparatus 1 from the inlet 77 to the outlet 52. The air 76 flows from the inlet 77 around an air passage 72 along the inner walls of the housing 53 and enters the open, inlet cavity/void 71 below the or each finned heat sink 61, 63 to expand such that air pressure decreases to about -500Pa to - 450Pa relative to ambient pressure. The air from the open cavity/void 71 adjacent to the LED mount then flows, i.e., is pulled into the finned heat sinks 61, 63 to carry heat away from the heat sinks 61, 63.

The air inlet 69 into the finned heat sinks 61, 63 controls i.e., throttles the air flow entering the finned heat sinks 61, 63 from the inlet cavity 71 of the housing 53 to create a turbulent flow of air through the finned heat sinks 61, 63. When the heated air 75 is carried out of the finned heat sinks 61, 63 it expands into the second cavity or outlet void 74 so that pressure decreases again.

The restriction 67a, 67b proximal to the or each finned heat sink 61, 63 reduces the cross sectional area of the air flow path from the open inlet cavity 71 below the finned heat sink 61, 63. The reduction in the cross sectional area of the air flow path from the inlet cavity 71 to the finned heat sinks 61, 63 is by a ratio of about 1:2.3 (inlet cavity:finned heat sink). The reduction in the cross-sectional area of the air flow path from the cavity 71 below the heat sinks 61, 63 to the or each finned heat sink 61, 63 reduces by more than 50%. In an example apparatus 51, the air inlet 69 between the outer wall of the thermal transfer member/ heat pipe 64 and the restriction 67a, 67b is about 8.5mm (A) so that the open area per heat sink is about 410mm². Air enters the finned heat sinks 61, 63 through the air inlet 69 and passes across the fins of the heat sinks 61, 63, wherein the distance (B) along, i.e., the length of each fin from the outer wall of the thermal transfer member/heat pipe 64, is about 19.5mm. When air flows into the heat sinks 61, 63, the restriction of the air flow by the first and second base members 67a, 67b causes significant turbulence of the air passing into the finned heatsinks 61, 63, which increases heat transfer from the fins to the surrounding air. This increases the cooling achieved by the finned heat sinks 61, 63.

The size and shape of the housing 53, the air inlet 77, the air passage 72, the cavity 71, the base supports 67a, 67b and the second cavity/outlet void 74 are carefully configured to decrease relative air pressure moving through the apparatus 1 and maximise cooling of the finned heat sinks 61, 63. The configuration of the present invention ensures that air flows through the apparatus 51 to carry heat away from the thermal transfer members 64, for example heat pipes 64 or metal rods (not shown) and ensures that cooling is substantially uniform along the length of the device 51. The air in the inlet cavity 71 below the finned heat sinks 61, 63 is at a higher pressure than the air in the outlet cavity 74 above the finned heat sinks 61, 63. The air pressure decreases when the air moves out of the finned heat sinks 61, 63 to the outlet cavity 74.
The air pressure outside the apparatus 51 at the air inlet 77 through which air is pulled into the apparatus 51 is about +101kPa. The air pressure decreases when the air reaches the open sections/cavities 71, 74 into which it expands. The air pressure in the inlet cavity 71 is about -600Pa relative to ambient pressure and the air pressure of the heated air 75 exiting the finned heat sinks 61, 63 that is pulled towards the air outlet 52 is about -1150Pa relative to ambient pressure.

The present invention can be configured for any length of apparatus - i.e., according to the required application. The ratios of the air path sections as air flows from the air inlet 77 to the air outlet 52 is controlled to achieve the required air flow and so uniform cooling along the length of the apparatus 51.

Examples of the cross-sectional areas of the air flow passage though each section of the apparatus 51 are set out in Table 1 below for an apparatus having a 30cm length:

**[Table 1]**

| Position | 30cm length apparatus cross sectional area of the air flow passage (mm²) |
|---|---|
| Air inlet (27) | 1964 |
| Air inlet into the finned heat sinks (19) | 3280 |
| Outlet cavity (24) | 3910 |
| Outlet ducting | 6718 |

Referring to Figure 10, in a preferred embodiment of the present invention, air 73 is pulled into the air inlet 77, which is along the length of the housing 53, from a single fan (not shown) at the air outlet 552 at a first end 6 at the rear of the housing 553. The fan can be connected to the housing 53 by ducting and the fan is positioned remotely from the apparatus 51. Referring to Figure 9, air 76 is pulled through the housing 53 and enters the cooling module 57 through the air inlet 69 between the first base member 67a and the second base member 67b. The air inlet 69 effectively controls the air flow entering the cooling module 57. The air inlet/gap 69 through which air enters the finned heat sinks 61, 63 chokes - i.e., restricts and controls the air flow into the finned heat sinks 61, 63. The air then passes along the plurality of fins and through the first and second finned heat sinks 61, 63 adjacent to the thermal transfer members 64, for example, heat pipes 64 or metal rods. The heated air 75 is pulled out of the housing 53 to the outlet cavity 74 and to the outlet 52 to exit and so cool the LED curing apparatus 51.

With reference to Figure 9, the uniformity of pressure, air flow and so cooling along the length of the apparatus 51 was measured by positioning sensors at fixed points (Position 1 - air inlet channel 72; Position 2 - air channel into open cavity 71 ; Position 3 - outlet cavity 74). It can be seen from the results shown in Table 2 below that the pressure measurements are substantially uniform along the length of the apparatus:

**[Table 2]**

| Gauge Pressure (Pa) - relative to ambient pressure | | | | |
|---|---|---|---|---|
| Measurement Point | Position along the length of the apparatus (mm) | | | |
| | 116.25 | 192.75 | 269.25 | 345.75 |
| 1 | -357 | -377 | -473 | -440 |
| 2 | -650 | -783 | -757 | -823 |
| 3 | -483 | -470 | -473 | -447 |

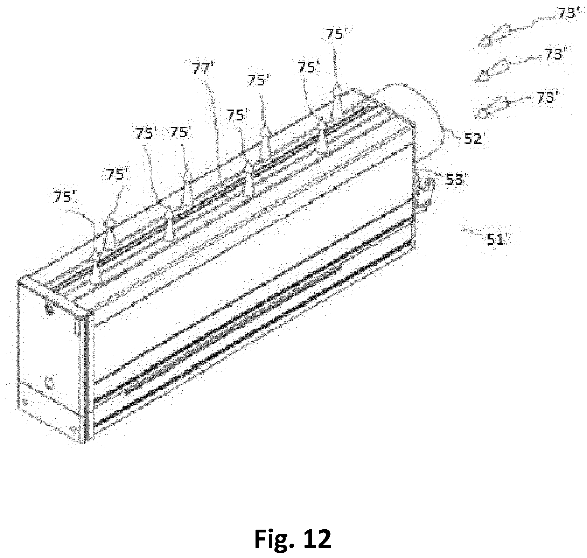

Referring to Figures 11 and 12, an LED curing apparatus 51' of an alternative embodiment is shown, cool air 73' is blown into and along the length of the housing 53' from a single fan (not shown) into the air inlet 52" at a first end (rear) of the housing 53'. The fan can be connected to the housing by ducting and the fan is positioned remotely from the apparatus 51'. The cool air 73' enters the cooling module 57' through the air inlet 69' between the first support 67a' and the second support 67b'. The air inlet 69' effectively controls the air flow entering the cooling module 57'. The air inlet/gap 69' through which air enters the finned heat sinks 61', 63' chokes - i.e., restricts and controls the air flow into the finned heat sinks 61', 63'. The air then passes along the plurality of fins and through the first and second finned heat sinks 61', 63' adjacent to the condenser section of the heat pipe. The heated air 75' rises upwards through the cooling module 57' to the outlet 77' to leave the housing 53'.

The above described embodiments have been given by way of example only, and the skilled reader will naturally appreciate that many variations could be made thereto without departing from the scope of the claims.

Within this specification embodiments have been described in a way which enables a clear and concise specification to be written, but it is intended and will be appreciated that embodiments may be variously combined or separated without parting from the invention. For example, it will be appreciated that all preferred features described herein are applicable to all aspects of the invention described herein and vice versa.

Within this specification, the term "about" means plus or minus 20%, more preferably, plus or minus 10%, even more preferably, plus or minus 5%, most preferably, plus or minus 2%.

Within this specification, the term "substantially" means a deviation of plus or minus 20%; more preferably, plus or minus 10%; even more preferably, plus or minus 5%, most preferably, plus or minus 2%. Within this specification, reference to "substantially" includes reference to "completely" and/or "exactly." That is, where the word substantially is included, it will be appreciated that this also includes reference to the particular sentence without the word substantially.

## Claims

1. An LED curing apparatus cooling system comprising at least one LED mount for mounting a plurality of LEDs; at least one bore in the LED mount;
at least one thermal transfer member wherein the or each thermal transfer member is removably connected to a bore; and
wherein each thermal transfer member comprises a collar having an outer surface to mate with an inner surface of a bore.

2. An LED curing apparatus cooling system according to claim 1 wherein the thermal transfer member is a heat pipe and the collar is attached to the evaporator section of the heat pipe.

3. An LED curing apparatus cooling system according to claim 1 wherein the thermal transfer member is a metal rod and the collar is attached to a first end of the metal rod.

4. An LED curing apparatus cooling system according to any preceding claim wherein the outer surface of the or each collar is shaped to mate with a shaped inner surface of a respective bore.

5. An LED curing apparatus cooling system according to any preceding claim wherein the outer surface of the or each collar comprises a threaded portion to mate with a threaded inner surface of a respective bore.

6. An LED curing apparatus cooling system according to any preceding claim wherein the or each collar is a connecting band; and/or wherein the or each collar is an annular band; and/or wherein the or each collar is cylindrical having a base at a first end and an opening at an opposing second end.

7. An LED curing apparatus cooling system according to any preceding claim wherein the or each thermal transfer member is soldered to a collar.

8. An LED curing apparatus cooling system according to any preceding claim wherein the or each LED mount comprises a thermal transfer material between the or each thermal transfer member and the bore; preferably, wherein the thermal transfer material has a thermal conductivity greater than about 5W/mK.

9. An LED curing apparatus cooling system according to claim 8 wherein the thermal transfer material is a ceramic paste.

10. An LED curing apparatus cooling system according to any preceding claim wherein the or each LED mount comprises a thermal transfer material provided between the collar and the bore to which the collar is removably connected.

11. An LED curing apparatus cooling system according to any preceding claim comprising one or more LEDs mounted on the LED mount.

12. An LED curing apparatus cooling system according to any preceding claim wherein the or each collar comprises copper.

13. An LED curing apparatus cooling system according to any preceding claim wherein the or each collar comprises a threaded portion and a non-threaded portion.

14. An LED curing apparatus cooling system according to any preceding claim wherein the or each bore is substantially cylindrical.

15. A cooling module for an LED curing apparatus comprising the LED curing apparatus cooling system according to any preceding claim wherein the or each thermal transfer member is also connected to at least one air-cooled finned heat sink.
